(19) Europäisches Patentamt
European Patent Office
Office européen des brevets

(11) EP 0 857 705 B1

(12) EUROPEAN PATENT SPECIFICATION

(45) Date of publication and mention
of the grant of the patent:
**31.07.2002 Bulletin 2002/31**

(51) Int Cl.[7]: **C04B 41/50**

(21) Application number: **98300663.6**

(22) Date of filing: **29.01.1998**

(54) **Method of producing coatings on electronic substrates**

Verfahren zur Herstellung von Überzügen auf Elektronikteilen

Procédé de fabrication de revêtements sur des parts éléctroniques

(84) Designated Contracting States:
**DE FR GB IT**

(30) Priority: **07.02.1997 US 789405**

(43) Date of publication of application:
**12.08.1998 Bulletin 1998/33**

(73) Proprietor: **DOW CORNING CORPORATION**
**Midland Michigan 48686-0994 (US)**

(72) Inventors:
• **Bremmer, Jeffrey Nicholas**
**Midland, Michigan 48640 (US)**

• **Liu, Youfan**
**Midland, Michigan 48640 (US)**

(74) Representative: **Hall, Marina**
**Elkington and Fife**
**Prospect House,**
**8 Pembroke Road**
**Sevenoaks, Kent TN13 1XR (GB)**

(56) References cited:
**EP-A- 0 510 872          EP-A- 0 604 779**
**US-A- 5 541 248**

**Description**

This invention provides a method of forming coatings on electronic substrates by applying to said substrate a hydrogen silsesquioxane resin (H-resin) and thereafter curing said resin at a temperature of less than 375°C for a time sufficient to convert the resin into an insoluble coating wherein the coating contains >85% SiH. These coatings show improved film stress over coatings containing ≤80% SiH.

The use of H-resin to produce ceramic coatings on electronic devices is known in the art. For example, U.S. Patent 4,756,977 describes a method for producing ceramic coatings by curing H-resin in an air environment. U.S. Patent 5,370,904 discloses a method for producing ceramic coatings by curing H-resin in an inert gas at a temperature of 250 to 500°C. until the content of the Si-bonded H in the silicon oxide product has reached ≤80% of the Si-bonded H in the starting hydrogen silsesquioxane. U.S. Patent 5,370,903 discloses a method for producing ceramic coatings by curing H-resin in an atmosphere containing >0% up to 20 vol% oxygen and 80 to <100 vol% nitrogen at temperatures of 250 to <500°C. until the content of the Si-bonded H in the silicon oxide product has reached ≤80% of the Si-bonded H in the starting hydrogen silsesquioxane. These patents all teach methods wherein the object is to produce $SiO_2$ ceramic coatings from the H-resin.

It has now been found that H-resin can be cured to an insoluble state even though the cured coating contains > 85% of the Si-bonded H in the starting resin. Unexpectedly, the cured resin with >85% retained SiH content has been found to exhibit desirable properties such as reduced film stress which make the coatings suitable for use in various electronic devices. This can be achieved without sacrificing other properties such as dielectric constant. Additionally, the coatings are less dense (more porous) than those produced by known curing methods.

This invention pertains to a method for producing a coating on an electronic substrate by heating H-resin at a temperature of 375°C. or less for a time sufficient such that the cured coating contains > 85% SiH. It has been found that the film stress of the coating is reduced when the resin is heated to 375°C. or less for a time sufficient such to produce an insoluble coating containing > 85% SiH.

The instant invention pertains to a method of producing a coating on an electronic substrate wherein the method comprises applying to the substrate a composition comprising H-resin and thereafter heating the hydrogen silsesquioxane at a temperature of 375°C. or less for a period of time sufficient to convert the hydrogen silsesquioxane resin into an insoluble coating containing >85% SiH. In addition to silicon bonded hydrogen (SiH), the insoluble coating may contain amorphous silica ($SiO_2$), amorphous silica-like materials that are not fully free of residual carbon, silanol (SiOH) and/or additional ceramic materials. By "insoluble" it is meant a SiH containing coating that is not soluble in the solvent from which the hydrogen silsesquioxane resin was dispensed to form the coating.

The hydrogen silsesquioxane resin which may be used in this invention includes hydridosiloxane resins containing units of the formula $HSi(OH)_x(OR)_yO_{z/2}$, in which each R is independently an organic group or a substituted organic group which, when bonded to silicon through the oxygen atom, forms a hydrolyzable substituent, x = 0 to 2, y = 0 to 2, z = 1 to 3, x + y + z = 3. Examples of R include alkyls such as methyl, ethyl, propyl, butyl, etc., aryls such as phenyl, and alkenyls such as allyl or vinyl. These resins may be fully condensed $(HSiO_{3/2})_n$ wherein n is an integer having a value of at least 8, preferably 8 to 1,000; or they may be only partially hydrolyzed (i.e., containing some Si-OR) and/or partially condensed (i.e., containing some Si-OH). Although not represented by this structure, these resins may also contain a small number (e.g., less than 10%) of silicon atoms which have either 0 or 2 hydrogen atoms attached thereto or a small number of SiC bonds due to various factors involved in their formation or handling.

The above H-resins and methods for their production are known in the art. For example, U.S. Patent 3,615,272 teaches the production of a nearly fully condensed H-resin (which may contain up to 100-300 ppm silanol) by a process comprising hydrolyzing trichlorosilane in a benzenesulfonic acid hydrate hydrolysis medium and then washing the resultant resin with water or aqueous sulfuric acid. Similarly, U.S. Patent 5,010,159 teaches an alternative method comprising hydrolyzing hydridosilanes in an arylsulfonic acid hydrate hydrolysis medium to form a resin which is then contacted with a neutralizing agent.

Other hydridosiloxane resins, such as those described by Frye et al. in U.S. Patent 4,999,397 those produced by hydrolyzing an alkoxy or acyloxy silane in an acidic, alcoholic hydrolysis medium, those described in JP-As 59-178749, 60-86017 and 63-107122, or any other equivalent hydridosiloxane, will also function herein.

It is noted that in a preferred embodiment of the invention, specific molecular weight fractions of the above H-resins may also be used in this process. Such fractions and methods for their preparation are taught in U.S. Patents 5,063,267 and 5,416,190. A preferred fraction comprises material wherein at least 75% of the polymeric species have a molecular weight above 1200 and a more preferred fraction comprises material wherein at least 75% of the polymeric species have a number average molecular weight of from 1200 to 100,000.

The hydrogen silsesquioxane resin may contain a platinum, rhodium or copper catalyst. Generally, any platinum, rhodium or copper compound or complex which can be solubilized will be functional. For instance, platinum acetylacetonate, rhodium catalyst $RhCl_3[S(CH_2CH_2CH_2CH_3)_2]_3$, obtained from Dow Corning Corporation, Midland, Michigan, or cupric naphthenate are all within the scope of this invention. These catalysts are added in an amount of 5 to 1000 ppm platinum, rhodium or copper based on the weight of H-resin.

The H-resin alternately, may also contain an organic or inorganic peroxide. Organic and inorganic peroxides useful in the instant invention may be exemplified by, but not limited to barium peroxide, strontium peroxide, calcium peroxide, $\alpha$, $\alpha$-bis tertiary peroxydiisopropylbenzene, dicumyl peroxide and benzoyl peroxide.

Other ceramic oxide precursors may also be used in combination with the above H-resin. The ceramic oxide precursors specifically contemplated herein include compounds of various metals such as aluminum, titanium, zirconium, tantalum, niobium and/or vanadium as well as various non-metallic compounds such as those of boron or phosphorous which may be dissolved in solution, hydrolyzed and subsequently pyrolyzed at relatively low temperatures to form ceramic oxides. The use of the ceramic oxide precursors is described in U.S. Patents 4,753,855 and 4,973,526.

The above ceramic oxide precursors generally have one or more hydrolyzable groups bonded to the above metal or non-metal, depending on the valence of the metal. The number of hydrolyzable groups to be included in these compounds is not critical as long as the compound is soluble or can be dispersed in the solvent. Likewise, selection of the exact hydrolyzable substituent is not critical since the substituents are either hydrolyzed or pyrolyzed out of the system. Typical hydrolyzable groups include, but are not limited to, alkoxy, such as methoxy, propoxy, butoxy and hexoxy, acyloxy, such as acetoxy, other organic groups bonded to said metal or non-metal through an oxygen such as acetylacetonate or amino groups. Specific compounds, therefore, include zirconium tetracetylacetonate, titanium dibutoxy diacetylacetonate, aluminum triacetylacetonate, tetraisobutoxy titanium and $Ti(N(CH_3)_2)_4$.

When a ceramic oxide precursor is combined with the H-resin, it is used in an amount such that the coating composition contains 0.1 to 30 wt% ceramic oxide precursor based on the weight of the H-resin.

Other materials may also be present in the coating composition. For example, adhesion promoters, suspending agents and other optional components may be added. The adhesion promoters are exemplified by, but not limited to, silanes such as glycidoxypropyltrimethoxysilane, mercaptopropyltrimethoxysilane and vinyl triacetoxysilane.

The H-resin may be applied to the substrate in any manner, but a preferred method involves producing a solvent dispersion of the H-resin and any optional components and applying the solvent dispersion to the surface of the substrate. Various facilitating means such as stirring and/or heating are used to dissolve or disperse the H-resin and create a more uniform application material.

Solvents which are used include any agent or mixture of agents which will dissolve the H-resin to form a homogeneous liquid mixture without affecting the resulting coating. These solvents include alcohols such as ethyl alcohol or isopropyl alcohol; aromatic hydrocarbons such as benzene or toluene; alkanes such as n-heptane, dodecane or nonane; ketones; esters; glycol ethers; or dimethylpolysiloxanes. The solvent is present in an amount sufficient to dissolve the H-resin to the concentration desired for application. Typically the solvent is present in an amount of 20 to 99.9 wt%, preferably from 50 to 99 wt%, based on the weight of the coating composition.

The H-resin may be applied to any substrate such as metal or ceramic, however, it is preferred to apply the hydrogen silsesquioxane resin to an electronic substrate. By "electronic substrate" it is meant to include silicon based devices and gallium arsenide based devices intended for use in the manufacture of a semiconductor component including focal plane arrays, opto-electronic devices, photovoltaic cells, optical devices, transistor-like devices, 3-D devices, silicon-on-insulator devices and super lattice devices. To further exemplify, electronic substrates include wafers resulting from the fabrication of integrated circuits and semiconductor devices. Typically the devices are completely fabricated up to the point of the interconnect system, usually bond pads, while still in the wafer stage. It is desirable and economical to apply these coatings to the electronic devices while they are still in the wafer stage as an electronic substrate. Such coated devices are then separated from each other and continued into the packaging and assembly stages. Alternately, the electronic substrates are the actual separated semiconductor devices or integrated circuit devices, before or after the interconnects are made to an electronic assembly.

Specific methods for application of the solvent dispersion include, but are not limited to, spin coating, dip coating, spray coating, flow coating, screen printing or others. The solvent is then allowed to evaporate from the coated substrate resulting in the deposition of the H-resin. Any suitable means for evaporation is used such as simple air drying by exposure to an ambient environment, by the application of a vacuum, or mild heat ($\leq 50°$) or during the early stages of the curing process. It should be noted that when spin coating is used, the additional drying method is minimized as the spinning drives off the solvent.

Following removal of any solvent, a coating of H-resin is formed on the substrate. Said coating is subjected to an intermediate heating in an inert atmosphere to melt and flow the H-resin. Typically, this intermediate heating is carried out at a temperature of from 150°C. to 400°C. and for very short periods of time. Due to the short periods of time that the coating is heating, there is no or incidental curing of the H-resin.

The coating is converted to an insoluble SiH containing coating by exposing the H-resin to a temperature of 375°C. or less, preferably at 350°C., for a time sufficient to convert said coating to an insoluble coating containing >85% SiH. The coatings are heated for a period of less than 10 hours, preferably from 0.5 to 1.5 hours to produce coatings having > 85% SiH.

The heating preferably takes place in an inert atmosphere, although other atmospheres may be used. Inert atmospheres useful herein include, but are not limited to, nitrogen, helium and argon, preferably nitrogen. The amount of SiH bond density in the final coating is determined based on the amount of SiH bond density in the soluble H-resin coating, as applied on the substrate.

Any method of heating such as the use of a convection oven, rapid thermal processing, hot plate, radiant or microwave energy may be used herein. The rate of heating is also not critical but is most practical and preferred to heat as rapidly as possible.

By these methods, a thin (less than 2 μm) insoluble SiH containing coating is produced on the substrate having improved film stress. The coating smoothes the irregular surfaces of the various substrates and has excellent adhesion properties.

Additional coatings may be applied over the insoluble SiH containing coating if desired. These can include, for example SiO$_2$ coatings, SiO$_2$/ceramic oxide layers, silicon containing coatings, silicon carbon containing coatings, silicon nitrogen containing coatings, silicon oxygen nitrogen containing coatings, silicon nitrogen carbon containing coatings and/or diamond like coatings produced from the deposition (i.e. chemical vapor deposition, plasma enhanced chemical vapor deposition, etc.) of amorphous SiC:H, diamond or silicon nitride. Methods for the application of such coatings are known in the art and are described, for example, in U.S. Patents 4,756,977 and 5,011,706.

The method of applying an additional coating such as silicon carbide is not critical, and such coatings can be applied by any chemical vapor deposition technique such as thermal chemical vapor deposition (TCVD), photochemical vapor deposition, plasma enhanced chemical vapor deposition (PECVD), electron cyclotron resonance (ECR), and jet vapor deposition. It could also be applied by physical vapor deposition techniques such as sputtering or electron beam evaporation. These processes involve either the addition of energy in the form of heat or plasma to a vaporized species to cause the desired reaction, or they focus energy on a solid sample of the material to cause its deposition.

So that those skilled in the art can understand and appreciate the invention taught herein, the following example is presented, it being understood that this example should not be used to limit the scope of this invention found in the claims.

"Soak Temperature" and "Soak Time" represent the temperature the furnace was heated to for curing and the amount of time that it was held at this temperature during the cure.

"Thickness After Cure" was determined by using a NanoSpec™/AFT Model 2100 Automated Film Thickness Instrument. Thickness was determined by a method of reflection spectroscopy whereby visible light is reflected from the surface of the measurement sample into a specially designed microscope. Film thickness is determined from the measured interferogram of reflection intensity as a function of wavelength with the use of a curve fitting algorithm provided by the vendor.

Dielectric Constant of the converted coating was determined by performing dielectric constant measurements on metal-insulator-semiconductor (MIS) capacitors. MIS capacitors were formed by depositing aluminum electrodes of approximately 0.15 μm in thickness onto low resistivity (ρ ≤ 0.025Ω cm) silicon wafers coated with a thin film of the insoluble coating. A shadow mask was utilized to form aluminum electrode dots of diameter ranging from 3 to 10 mm. Impedance measurements were made across electrode dots of same diameter over frequency range of 0.1 - 1000 kHz using a Hewlett-Packard™ 4194A Impedance Analyzer. The impedance data was fit to a series RLC model from which the equivalent parallel capacitance and dielectric constant were calculated. Since impedance was characterized across the surface dot electrodes, twice the dielectric thickness was used for dielectric constant measurements.

%SiH remaining after cure was determined by Fourier Transform Infrared Spectroscopy. This method comprised using a Nicolet™ 5SXB FTIR Spectrometer. A transmission sampling mode of operation was utilized. Prior to the spin coating of the wafer with the coating composition, a background spectra was collected on bare silicon wafers. The background was subtracted from a wafer having the insoluble film thereon to obtain spectra of the insoluble film only. A peak at wavenumber 2260 cm$^{-1}$ is indicative of the SiH bond density in the converted film. A ratio of this peak area per film thickness to an as spun film peak area per thickness was quantified to determine the normalized SiH bond density.

"Film Stress" was determined by using a Tencor™ P-1 Long Scan Profilometer. Stress was calculated from the change in wafer curvature as measured over the center 90% of the wafer diameter. The following relationship was utilized to calculate stress based on thin film stress modeled by a beam bending method.

$$\sigma = (1/6R)^*(E/(1-\upsilon))^*(t_s^2/t_f)$$

where

σ = film stress
R = radius of curvature
E/(1-ν) = substrate elastic constant

$t_s$ = substrate thickness

$t_f$ = film thickness

"Film Density" was determined by separately characterizing mass and volume of the film on wafer. A gravimetric method was utilized to determine mass with a Metler™ AE240 mass balance by subtracting the wafer mass from the wafer with film after thermal processing. Volume of film was determined from the product of film thickness and film area on wafer. Reported density is an average of three films.

EXAMPLE 1

Sample wafers were coated with a coating composition comprising 22 wt% hydrogen silsesquioxane resin $(HSiO_{3/2})_n$ prepared according to U.S. Patent 3,615,272 in methyl isobutyl ketone to a pre-cured thickness of 0.52 $\mu$m on a SEMIX™ 6132U spin coater followed by sequential bakes on three open ended nitrogen purged hot plates at 150, 200, and 350°C. for one minute each. The wafers were then heated in a quartz tube furnace heated to 350°C. under a nitrogen atmosphere. Results are given in Table 1. These results demonstrate that when there is > 85% SiH in the final coating, the film stress is significantly improved.

Table 1: Example 1 Conditions and Results

| Run No. | Soak Temp (°C) | Soak Time (hr) | Thickness After Cure (Å) | % SiH Remaining After Cure | Dielectric Constant | Film Stress (MPa) | Film Density (g/cc) |
|---|---|---|---|---|---|---|---|
| 1 | 350 | 0.5 | 5259 | 89 | 2.8 | 48 | 1.40 |
| 2 | 350 | 1 | 5033 | 89 | 2.8 | 43 | 1.40 |
| 3 | 350 | 1 | 5192 | 87 | 2.9 | 49 | 1.36 |
| 4 | 350 | 1.5 | 5243 | 87 | 2.9 | 43 | 1.42 |
| C-5 | 350 | 10 | 5106 | 80 | n.d | 55 | n.d |
| C-6 | 350 | 20 | 5090 | 67 | 2.8 | 95 | n.d |
| C-7 | 350 | 40 | 4923 | 52 | 2.8 | 127 | n.d |

n.d. = not determined

1Å = 0.1 nm

## Claims

1. A method of forming an insoluble coating on a substrate wherein said method comprises

(A) coating the substrate with a coating composition comprising a soluble hydrogen silsesquioxane resin (H-resin) to form a soluble H-resin coating on the substrate;
(B) heating the soluble H-resin coating to a temperature of 375°C or less for a period of time sufficient to convert said H-resin into an insoluble coating retaining in the insoluble coating >85% of the silicon-bonded hydrogen from the soluble H-resin.

2. The method of claim 1 wherein the H-resin is a resin having units of the formula $HSi(OH)_x(OR)_yO_{z/2}$, in which each R is independently an organic group or a substituted organic group which, when bonded to silicon through the oxygen atom, forms a hydrolyzable substituent, x = 0 to 2, y = 0 to 2, z = 1 to 3 and x + y + z = 3.

3. The method of claim 1 wherein the H-resin is a resin having the formula $(HSiO_{3/2})_n$ wherein n is an integer having a value of at least 8.

4. The method of any of claims 1 to 3 wherein the coating composition further comprises a catalyst containing an element selected from the group consisting of platinum, rhodium and copper.

5. The method of claim 4 wherein the catalyst is present in an amount sufficient to provide 5 to 1000 ppm of platinum, rhodium or copper based on the weight of the hydrogen silsesquioxane resin.

6. The method of any of claims 1 to 5 wherein the coating composition further contains a ceramic oxide precursor comprising a compound containing an element selected from the group consisting of aluminum, titanium, zirconium, tantalum, niobium, vanadium, boron and phosphorous wherein said compound contains at least one hydrolyzable substituent selected from alkoxy or acyloxy and said compound is present in an amount such that the coating composition contains from 0.1 to 30 wt% of said precursor based on the weight of H-resin.

7. The method of any of claims 1 to 6 wherein the said composition additionally comprises a solvent and said solvent is evaporated to form said resin coating on said substrate.

8. The method of claim 7 wherein the coating composition contains from 20 to 99.9 wt% solvent based on the weight of the coating composition.

9. The method of claim 7 or claim 8 wherein the solvent is selected from the group consisting of alcohols, aromatic hydrocarbons, alkanes, ketones, esters, glycol ethers, and dimethylpolysiloxanes.

10. The method of any of claims 1 to 9 wherein said substrate is coated by spin coating.

11. The method of any of claims 1 to 10 wherein the substrate is an electronic substrate.

12. The coating obtainable by the method as claimed in any of claims 1 to 11.

**Patentansprüche**

1. Verfahren zur Ausbildung einer unlöslichen Beschichtung auf einem Substrat, wobei das Verfahren umfasst:

(A) Beschichten des Substrats mit einer Beschichtungszusammensetzung, die ein lösliches Wasserstoffsilsesquioxanharz (H-Harz) enthält, um eine lösliche K-Harzbeschichtung auf dem Substrat auszubilden;
(B) Erhitzen der löslichen H-Harzbeschichtung auf eine Temperatur von 375°C oder weniger für einen Zeitraum, der ausreicht, um dieses H-Harz in eine unlösliche Beschichtung umzuwandeln, wobei in der unlöslichen Beschichtung >85% des siliciumgebundenen Wasserstoffs von dem löslichen H-Harz erhalten bleiben.

2. Verfahren nach Anspruch 1, worin das H-Harz ein Harz mit Einheiten der Formel $HSi(OH)_x(OR)_yO_{Z/2}$ ist, in denen jedes R unabhängig voneinander eine organische Gruppe oder eine substituierte organische Gruppe ist, die, wenn sie an Silicium über das Sauerstoffatom gebunden ist, einen hydrolysierbaren Substituenten bildet, x gleich 0 bis 2 ist, y gleich 0 bis 2 ist, z gleich 1 bis 3 ist und x+y+z gleich 3 ist.

3. Verfahren nach Anspruch 1, worin das H-Harz ein Harz mit der Formel $(HSiO_{3/2})_n$ ist, worin n eine ganze Zahl mit einem Wert von mindestens 8 ist.

4. Verfahren nach einem der Ansprüche 1 bis 3, worin die Beschichtungszusammensetzung weiterhin einen Katalysator enthält, der ein Element enthält, das aus der Gruppe ausgewählt ist, die aus Platin, Rhodium und Kupfer besteht.

**5.** Verfahren nach Anspruch 4, worin der Katalysator in einer Menge vorliegt, die ausreicht, um 5 bis 1000 ppm Platin, Rhodium oder Kupfer, bezogen auf das Gewicht des Wasserstoffsilsesquioxanharzes, zur Verfügung zu stellen.

**6.** Verfahren nach einem der Ansprüche 1 bis 5, worin die Beschichtungszusammensetzung weiterhin einen keramischen Oxidvorläufer enthält, der eine Verbindung enthält, die ein Element enthält, das aus der Gruppe ausgewählt ist, die aus Aluminium, Titan, Zirkonium, Tantal, Niob, Vanadium, Bor und Phosphor besteht, wobei diese Verbindung mindestens einen hydrolysierbaren Substituenten enthält, der aus Alkoxy oder Acyloxy ausgewählt ist, und diese Verbindung in einer Menge vorliegt, so dass die Beschichtungszusammensetzung 0,1 bis 30 Gew.-% dieses Vorläufers, bezogen auf das Gewicht des H-Harzes, enthält.

**7.** Verfahren nach einem der Ansprüche 1 bis 6, worin diese Zusammensetzung zusätzlich ein Lösungsmittel enthält und dieses Lösungsmittel verdampft wird, um die Harzbeschichtung auf dem Substrat auszubilden.

**8.** Verfahren nach Anspruch 7, worin die Zusammensetzung von 20 bis 99.9 Gew.-% Lösungsmittel bezogen auf Gewicht der Beschichtungszusammensetzung enthält.

**9.** Verfahren nach Anspruch 7, worin das Lösungsmittel aus der aus Alkoholen, aromatischen Kohlenwasserstoffen, Alkanen, Ketonen. Estern. Glycolethern und Dimethylpolysiloxanen bestehenden Gruppe ausgewählt ist.

**10.** Verfahren nach einem der Ansprüche 1-9, worin das Substrat durch Spinbeschichtung beschichtet wird.

**11.** Verfahren nach einem der Ansprüche 1-10. worin das Substrat ein elektronisches Substrat ist,

**12.** Beschichtung erhältlich durch das Verfahren nach einem der Ansprüche 1-11.

**Revendications**

**1.** Procédé de fabrication d'un revêtement insoluble sur un substrat selon lequel ledit procédé comprend les étapes consistant à :

(A) revêtir le substrat avec une composition de revêtement comprenant une résine de silsesquioxane d'hydrogène soluble (résine H) pour former un revêtement de résine H soluble sur le substrat ;
(B) chauffer le revêtement de résine H soluble à une température de 375°C ou une température inférieure pendant un intervalle de temps suffisant pour transformer ladite résine H en un revêtement insoluble contenant dans le revêtement insoluble plus de 85 % de l'hydrogène lié au silicium à partir de la résine H soluble.

**2.** Procédé selon la revendication 1, selon lequel la résine H est une résine ayant des unités de formule $HSi(OH)_x(OR)_yO_{z/2}$, dans laquelle chaque R est indépendamment un groupe organique ou un groupe organique substitué qui, lorsqu'il est lié au silicium par l'intermédiaire d'un atome d'oxygène, forme un substituant susceptible d'être hydrolysé, x = 0 à 2, y = 0 à 2, z = 1 à 3, et x + y + z = 3.

**3.** Procédé selon la revendication 1, selon lequel la résine H est une résine de formule $(HSiO_{3/2})_n$, dans laquelle n est un nombre entier ayant une valeur d'au moins 8.

**4.** Procédé selon l'une quelconque des revendications 1 à 3, selon lequel la composition de revêtement comprend en outre un catalyseur contenant un élément choisi parmi le groupe formé par le platine, le rhodium et le cuivre.

**5.** Procédé selon la revendication 4, selon lequel le catalyseur est présent en une quantité suffisante pour fournir de 5 à 1 000 ppm de platine, de rhodium ou de cuivre en se basant sur le poids de la résine de silsesquioxane d'hydrogène.

**6.** Procédé selon l'une quelconque des revendications 1 à 5, selon lequel la composition du revêtement contient en outre un précurseur d'oxyde céramique comprenant un composé contenant un élément choisi dans le groupe formé par l'aluminium, le titane, le zirconium, le tantale, le niobium, le vanadium, le bore et le phosphore dans lequel ledit composé contient au moins un substituant susceptible d'être solubilisé choisi parmi les alkoxy ou les acyloxy et ledit composé est présent en une quantité telle que la composition de revêtement contient entre 0,1 et 30 % en poids dudit précurseur en se basant sur le poids de la résine H.

7. Procédé selon l'une quelconque des revendications 1 à 6, selon lequel ladite composition comprend en plus un solvant et ledit solvant est évaporé pour former ledit revêtement de résine appliqué sur ledit substrat.

8. Procédé selon la revendication 1, selon lequel la composition de catalyseur contient de 20 à 99,9 % de solvant en se basant sur le poids de la composition de résine.

9. Procédé selon la revendication 7 ou 8, selon lequel le solvant est choisi dans le groupe formé par les alcools, les hydrocarbures aromatiques, les alcanes, les cétones, les esters, les éthers de glycol et les diméthylpolysiloxanes.

10. Procédé selon l'une quelconque des revendications 1 à 9, selon lequel ledit substrat est revêtu par revêtement par centrifugation.

11. Procédé selon l'une quelconque des revendications 1 à 10, selon lequel le substrat est un substrat électronique.

12. Revêtement pouvant être obtenu par le procédé selon l'une des revendications 1 à 11.